# EUROPEAN PATENT APPLICATION

(11) **EP 2 436 802 A1**
(43) Date of publication of application: **04.04.2012**
(21) Application number: 10780508.7
(22) Date of filing: 24.05.2010
(51) Int. Cl.: C23C 16/44, H01L 21/3065, H01L 21/683

(54) **STRUCTURE OF SUBSTRATE SUPPORTING TABLE, AND PLASMA PROCESSING APPARATUS**

(30) Priority: 29.05.2009 JP 2009129842
(71) Applicant: Mitsubishi Heavy Industries, Ltd., Tokyo 108-8215 (JP)
(72) Inventor: MATSUDA Ryuichi, Takasago-shi Hyogo 676-8686 (JP); YOSHIDA Kazuto, Kobe-shi Hyogo 652-8585 (JP)
(74) Representative: Siegert, Georg
(86) International application number: PCT/JP2010/058731
(87) International publication number: WO 2010/137553

(57) **Abstract**

Disclosed is the structure of a substrate supporting table wherein corrosion of a bellows is eliminated, generation of dusts from the bellows is suppressed, and the volume and the weight of the sections to be driven are reduced. A plasma processing apparatus is also disclosed. In the substrate supporting table for the plasma processing apparatus (10), a cylindrical inner tube (12), the bellows (13), an outer tube (14) and a cover member (15) are sequentially disposed concentrically from the inner side, and a drive member (21) to be driven by means of a drive mechanism (24) is attached to the rear surface of the placing table (16) through an opening (llb) and the inside of the inner tube (12).

## Description

### TECHNICAL FIELD

The present invention relates to a structure of a substrate supporting table which supports a substrate on an upper surface thereof and which is vertically moveable, and also to a plasma processing apparatus having the structure of the substrate supporting table.

### BACKGROUND ART

Among processing apparatuses which perform desired processing in a vacuum, an apparatus capable of changing the position of a substrate to be processed is known as a conventional art (Patent Documents 1, 2). For example, among plasma processing apparatuses for manufacturing a semiconductor device, specifically, plasma CVD (Chemical Vapor Deposition) apparatuses and plasma etching apparatuses, there is known an apparatus including a substrate supporting table capable of adjusting the position of a substrate against plasma. In such a plasma processing apparatus, a processing rate, an in-plane uniformity, and plasma damage can be adjusted to desired states by adjusting the distance between the substrate and the plasma. Thus, a plasma processing apparatus with a higher degree of freedom is achieved.
Patent Document 1: Japanese Patent Application Publication No. 2003-229408
Patent Document 2: Japanese Patent Application Publication No. 2003-289068

### DISCLOSURE OF THE INVENTION

### PROBLEMS TO BE SOLVED BY THE INVENTION

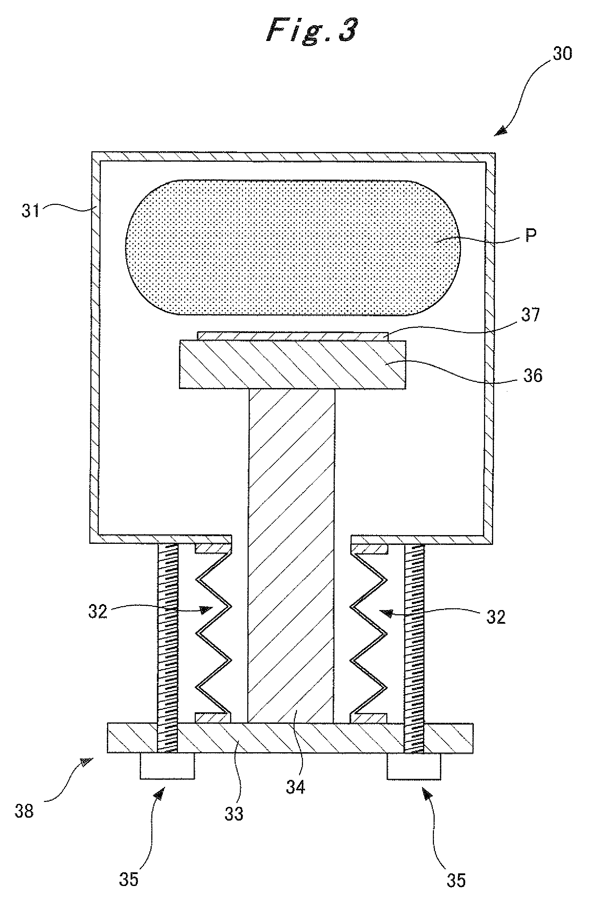

Fig. 3 shows a cross-sectional view of a conventional plasma processing apparatus, and problems of the conventional plasma processing apparatus will be described together with the outline thereof. Note that, illustrations of a plasma generation mechanism, a gas supplying mechanism, a vacuum mechanism, and the like are omitted in Fig. 3.
As shown in Fig. 3, in a conventional plasma processing apparatus 30, a substrate 37 is placed on a placing table 36 disposed inside a vacuum chamber 31, and desired plasma processing is performed on the substrate 37 by using plasma P generated in the vacuum chamber 31. The position of the substrate 37 during the plasma processing is adjustable against the plasma P by a drive mechanism 38.

Specifically, the drive mechanism 38 includes: a drive member 34 which supports the placing table 36 from below; a drive plate 33 which supports the drive member 34; and multiple ball screws 35 by which the drive plate 33 is supported moveably. The drive plate 33, the drive member 34, the placing table 36, and the substrate 37 are vertically moved by rotating the ball screws 35, so that the position of the substrate 37 against the plasma P is adjusted. Moreover, a bellows 32 is provided between a bottom portion of the vacuum chamber 31 and the drive plate 33. The bellows 32 allows the vertical movement of the drive mechanism 38 while maintaining a vacuum inside the vacuum chamber 31.

As shown in Fig. 3, the conventional plasma processing apparatus 30 has a structure in which the bellows 32 is disposed at a position directly below the placing table 36. Such a structure, however, has the following problems.
(1) A bellows made of stainless steel is generally used. When the bellows is exposed to a corrosive gas in a high temperature state, corrosion thereof progresses, thereby shortening the life of the bellows and causing metal contamination. Particularly, in the plasma processing apparatus, the placing table is generally heated to a high temperature of about 400°C and a corrosive gas such as NF₃, CF₄, or SF₆ is used as an etching gas (cleaning gas). Thus, the bellows is used in an environment in which corrosion is likely to occur.
(2) To avoid corrosion, the bellows should be provided at a position distant from the corrosive gas and the high temperature portion. However, if the placing table and the bellows are distant from each other (see Fig. 3), the volume and weight of a driven portion increases, and a large load is applied to the drive mechanism. In addition, if the volume and weight of the driven portion increases, the workability in maintenance is deteriorated, and the burden of maintenance is increased.
(3) Products from the plasma processing adhere to surfaces of the components inside the vacuum chamber. When the products adhere to a surface of the bellows, the adhered products are peeled off by the extraction and contraction of the bellows itself, and become a cause of particles.

The present invention is made in view of the problems described above, and an object thereof is to provide a structure of a substrate supporting table and a plasma processing apparatus in which corrosion of a bellows and generation of particles from the bellows are suppressed and also a driven portion is reduced in volume and weight.

### MEANS FOR SOLVING THE PROBLEMS

A structure of a substrate supporting table according to a first invention for solving the above problems is a structure of a substrate supporting table which is used in a processing apparatus using a corrosive gas in a vacuum chamber, and which includes a drive mechanism to change a position of a substrate to be processed, the structure comprising:
a cylindrical inner tube which has one end portion thereof attached to a periphery of an opening in an inner wall of the vacuum chamber with a first sealing member in between;
a bellows which is disposed on an outer circumferential side of the inner tube, and which has one end portion thereof attached to another end portion of the inner tube with a second sealing member in between;
a cylindrical outer tube which is disposed on a outer circumferential side of the bellows, and which has one end portion thereof attached to another end portion of the bellows with a third sealing member in between;
a disc-shaped placing table which is attached to close an opening in another end portion of the outer tube with a fourth sealing member in between, and on which the substrate is placed;
a cover member which is provided in tight contact with the outer tube to cover an entire surface of the outer tube, and which is made of a corrosion resistant material; and
a drive member which is attached to a back surface of the placing table through the opening in the inner wall of the vacuum chamber and an inside of the inner tube, and which is driven by the drive mechanism.

A structure of a substrate supporting table according to a second invention for solving the above problems is a structure of a substrate supporting table which is used in a processing apparatus using a corrosive gas in a vacuum chamber, and which includes a drive mechanism to change a position of a substrate to be processed, the structure comprising:
a cylindrical inner tube which has a lower end portion thereof attached to a periphery of an opening in a bottom portion of the vacuum chamber with a first sealing member in between;
a bellows which is disposed on an outer circumferential side of the inner tube, and which has an upper end portion thereof attached to an upper end portion of the inner tube with a second sealing member in between;
a cylindrical outer tube which is disposed on an outer circumferential side of the bellows, and which has a lower end portion thereof attached to a lower end portion of the bellows with a third sealing member in between;
a disc-shaped placing table which is attached to close an opening in an upper end portion of the outer tube with a fourth sealing member in between, and on which the substrate is placed;
a cylindrical cover member which is provided in tight contact with the outer tube to cover an entire surface of the outer tube, and which is made of a corrosion resistant material; and
a drive member which is attached to a back surface of the placing table through the opening in the inner wall of the vacuum chamber and an inside of the inner tube, and which is driven by the drive mechanism.

Specifically, when any of the structures of the substrate supporting tables according to the first and second inventions described above is employed, the cylindrical inner tube, bellows, outer tube, and cover member are disposed concentrically in this order from the inner side while maintaining a vacuum in the vacuum chamber. Moreover, a driven portion driven by the drive member includes members between the bellows and the placing table; that is, only the bellows, the outer tube, the cover member, and the placing table are driven.

A structure of a substrate supporting table according to a third invention for solving the above problems is the structure of the substrate supporting table according to the first or second invention, wherein at least one of bonding of the inner tube and the bellows, which is performed instead of using the second sealing member, and bonding of the bellows and the outer tube, which is performed instead of using the third sealing member, is performed.

A structure of a substrate supporting table according to a fourth invention for solving the above problems is the structure of the substrate supporting table according to any one of the first to third inventions, wherein a cylindrical exterior member made of a corrosion resistant material is further provided on an outer circumferential side of the cover member to cover an entire surface of the cover member.

A structure of a substrate supporting table according to a fifth invention for solving the above problems is the structure of the substrate supporting table according to any one of the first to fourth inventions, wherein the processing apparatus is a plasma processing apparatus.
Moreover, a plasma processing device according to a sixth invention for solving the above problems is a plasma processing device comprising the structure of the substrate supporting table according to any one of the first to fourth inventions.

### EFFECTS OF THE INVENTION

In the first to third inventions, the inner tube, the bellows, the outer tube, and the cover member are disposed concentrically in this order from the inner side. Thus, the bellows is protected by the outer tube and the cover member, and are therefore less likely to be exposed to a corrosive gas. Hence, corrosion of the bellows can be suppressed, and metal contamination due to the corrosion can be also suppressed. Particularly, when the temperature of the placing table is controlled to be a high temperature of, for example, 400°C, there has been a possibility of high temperature corrosion of the bellows. However, since the outer tube and the cover member exist between the placing table and the bellows, the temperature of the bellows itself does not rise to a high temperature. Thus, the high temperature corrosion is suppressed and the metal contamination due to the high temperature corrosion is also suppressed. Moreover, a driven portion driven by the drive member includes only the bellows, the outer tube, the cover member, and the placing table. Thus, the volume and weight of the driven portion can be reduced compared to a conventional one. Hence, loads on the bellows and the drive mechanism can be reduced. In addition, in the case where the drive mechanism fails and the placing table is thereby pushed to the vacuum side by the atmosphere on the back-surface side of the placing table, the bellows deforms in the direction to contract. Thus, the bellows does not expand and break, and the safety of the apparatus can be secured. The above facts make it possible to improve the performance and reliability of the structure of the substrate supporting table.

In the fourth invention, the exterior member having corrosion resistance is further provided on the outer circumferential side of the cover member. Thus, the corrosion of the bellows can be further suppressed.

In the fifth and sixth invention, the structure of the substrate supporting table of any one of the first to fourth inventions is applied to a plasma processing apparatus. Thus, products from the plasma processing are less likely to adhere to the surface of the bellows, protected inside the outer tube, the cover member, and the like. Hence, when the bellows expands and contracts, particles itself are generated less.

### BRIEF DESCRIPTION OF THE DRAWINGS

[Fig. 1] Fig. 1 is a cross-sectional view showing an example of an embodiment of a structure of a substrate supporting table of the present invention, and illustrates the substrate supporting table moved to a lower position in a plasma CVD apparatus.
[Fig. 2] Fig. 2 is a cross-sectional view showing the example of the embodiment of the structure of the substrate supporting table of the present invention, and illustrates the substrate supporting table moved to an upper position in the plasma CVD apparatus.
[Fig. 3] Fig. 3 is a cross-sectional view of a conventional plasma processing apparatus.

### EXPLANATION OF THE REFERENCE NUMERALS

- 10: PLASMA CVD APPARATUS
- 11: VACUUM CHAMBER
- 12: INNER TUBE
- 13: BELLOWS
- 14: OUTER TUBE
- 15: COVER MEMBER
- 16: PLACING TABLE
- 17: SUBSTRATE
- 18: SKIRL MEMBER
- 20: GATE DOOR
- 21: DRIVE MEMBER
- 22: DRIVE PLATE
- 23: BALL SCREW

### BEST MODES FOR CARRYING OUT THE INVENTION

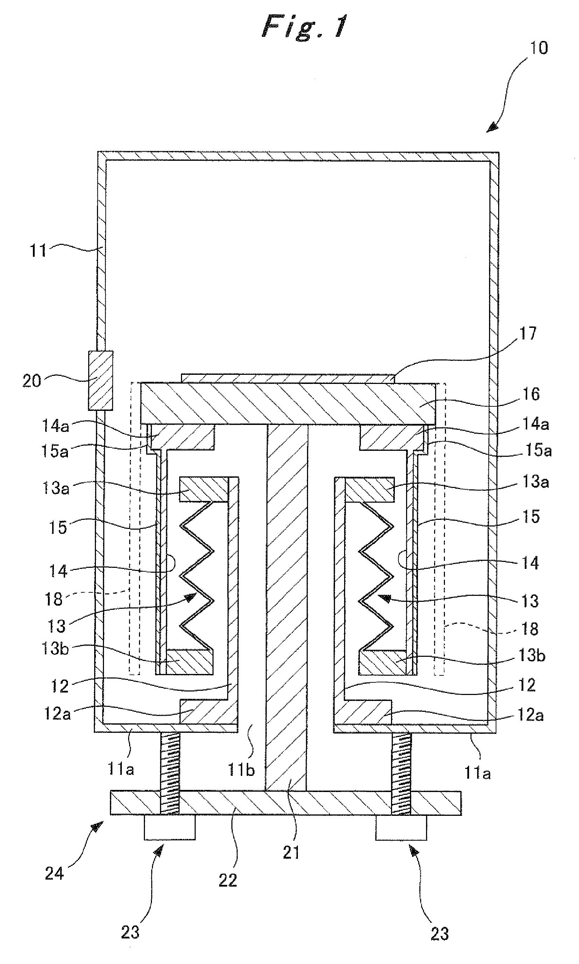

An embodiment of a structure of a substrate supporting table of the present invention will be described with reference to Figs. 1 to 2. Note that, a plasma CVD apparatus is given as an example in this description. However, the present invention is applicable not only to the plasma CVD apparatus but also to a plasma etching apparatus, and is also applicable to any other processing apparatus which moves a supporting table supporting an object to be processed in a vacuum chamber and which uses a corrosive gas in the vacuum chamber.

### (Embodiment 1)

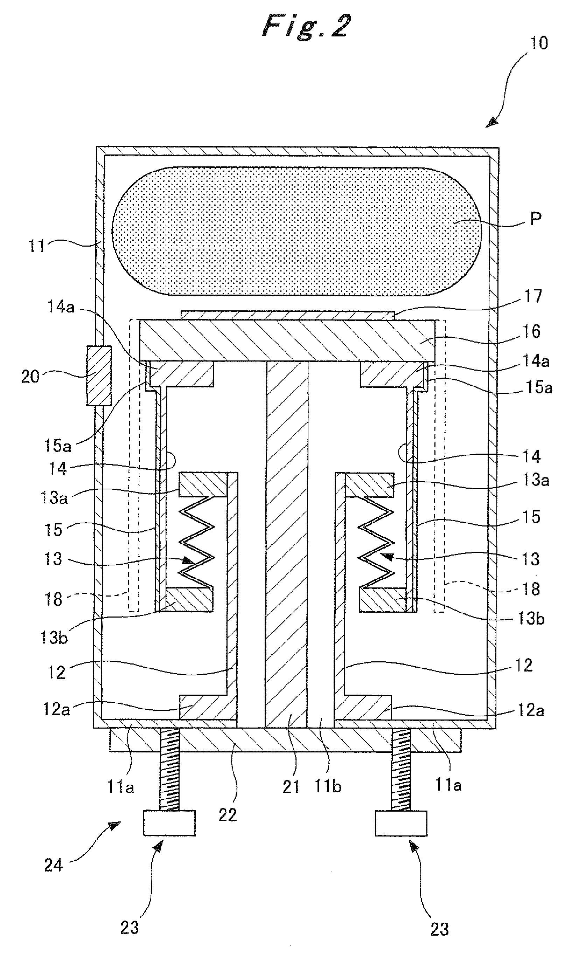

Figs. 1 and 2 are cross-sectional views showing an example of the embodiment of the structure of the substrate supporting table of the present invention. Fig. 1 illustrates the substrate supporting table at a lower position in a plasma CVD apparatus, whereas Fig. 2 illustrates the substrate supporting table at an upper position. Note that, illustrations of a plasma generation mechanism, a gas supplying mechanism, a vacuum mechanism, and the like are omitted in Figs. 1 and 2.

In the embodiment, a plasma processing apparatus 10 includes a vacuum chamber 11 in which a vacuum is created, and a disc-shaped placing table 16 which is disposed inside the vacuum chamber 11 and on which a substrate 17 is placed.

The placing table 16 is supported by a supporting structure described below. Specifically, the supporting structure includes a cylindrical inner tube 12, a bellows 13, and a cylindrical outer tube 14. The inner tube 12 has a lower flange 12a, which is a lower end portion (or one end portion) thereof, attached to a periphery of an opening 11b in a bottom portion 11a (or inner wall) of the vacuum chamber 11. The bellows 13 is disposed on the outer circumferential side of the inner tube 12, and has an upper flange 13a, which is an upper end portion (or one end portion) thereof, attached to an outer circumferential surface of an upper end portion (or the other end portion) of the inner tube 12. The outer tube 14 is disposed on the outer circumferential side of the bellows 13, and has a lower end portion (or one end portion) thereof attached to a lower flange 13b, which is a lower end portion (or the other end portion) of the bellows 13. The placing table 16 is attached to an upper flange 14a to close an opening in an upper end portion (or the other end portion) of the outer tube 14. Moreover, a cover member 15 is provided on an outer circumference of the outer tube 14, the cover member 15 in tight contact with an outer circumference surface to cover the entire surface of the outer tube 14. In other words, a structure is provided in which, in a region directly below the placing table 16, the inner tube 12 is disposed on the innermost side, and the cylindrical inner tube 12, the bellows 13, the outer tube 14, and the cover member 15 being mutually different in diameter are disposed concentrically in this order from the inner side.

Moreover, the bottom portion 11a and the lower flange 12a are attached to each other with a sealing member (first sealing member) such as an O-ring in between. Similarly, the inner tube 12 and the upper flange 13a are attached to each other with a sealing member (second sealing member) such as an O-ring in between; the lower flange 13b and the outer tube 14 are attached to each other with a sealing member (third sealing member) such as an O-ring in between; and the upper flange 14a and the placing table 16 are attached to each other with a sealing member (fourth sealing member) such as an O-ring in between. In other words, the vacuum chamber 11, the inner tube 12, the bellows 13, the outer tube 14, and the placing table 16 are attached to one another with a sealing member in between. This configuration allows a vertical movement of a drive mechanism 24 to be described later, while maintaining a vacuum inside the vacuum chamber 11. Note that, for the inner tube 12, the bellows 13, and the outer tube 14, at least one of a pair of the inner tube 12 and the bellows 13 and a pair of the bellows 13 and the outer tube 14 may be bonded and integrated together by welding in a way that there is no leakage, so as to maintain a vacuum.

Among the inner tube 12, the bellows 13, and the outer tube 14, at least the outer tube 14 is desirably made of a metal or an alloy having a relatively high melting point such for example as stainless steel to maintain the structure supporting the placing table 16 under a high temperature. Moreover, the cover member 15 is made of a corrosion resistant material such for example as aluminum whose surface is anodized or a ceramics such as high-purity alumina to avoid high-temperature corrosion of the outer tube 14 by a corrosive gas. It is particularly desirable that a portion of the upper flange 14a in direct contact with the placing table 16 be in tight contact with the cover member 15 without a gap, since the placing table 16 is sometimes set to a high temperature of about 400°C. For example, if the upper flange 14a protrudes to an outer circumferential side thereof as shown in Figs. 1 and 2, an upper end portion 15a of the cover member 15 is formed following conformity with the shape of the upper flange 14a, and put in tight contact without a gap. As a result, the outer tube 14 is exposed to the corrosive gas as little as possible.

Note that, a cylindrical skirt member (exterior member) 18 may be provided on the outer circumferential side of the cover member 15 to cover the entire surface of the cover member 15. The skirt member 18 is made of a corrosion resistant material as similar to the cover member 15, and is made of, for example, aluminum whose surface is anodized or a ceramics such as a high-purity alumina. Provision of the skirt member 18 allows a gas flowing on the outer circumferential side of the skirt member 18 to be regulated, and also prevents the gas from moving toward the outer tube 14, the bellows 13, and the inner tube 12. As a result, corrosion of the outer tube 14, bellows 13, and inner tube 12 is prevented. Thus, metallic contamination due to the corrosion is prevented, and the product lives of these parts are extended.

The placing table 16 can be vertically moved by the drive mechanism 24. Specifically, the drive mechanism 24 includes: a drive member 21 which is attached to a back surface of the placing table 16 through the opening 11b and the inside of the inner tube 12; a drive plate 22 which supports the drive member 21; and multiple ball screws 23 by which the drive plate 22 is supported moveably. The drive plate 22, the drive member 21, the placing table 16, and the substrate 17 are vertically moved by rotating the ball screws 23, so that the position of the substrate 17 is changed.

When the substrate 17 is to be placed on the placing table 16, the placing table 16 is disposed at the lower position as shown in Fig. 1, and the substrate 17 is placed through a gate door 20 by using an unillustrated robot arm. Meanwhile, when the substrate 17 placed on the placing table 16 is to be subjected to plasma processing, the placing table 16 is disposed at the upper position as shown in Fig. 2, and the position against the plasma P is adjusted. Thus, plasma processing from which a desired processing result can be obtained is performed.

In the structure described above, the outer tube 14 is protected by the cover member 15. Therefore, even when the placing table 16 is heated to about 400°C, a high temperature portion is less likely to be exposed to the corrosive gas. Thus, high temperature corrosion is suppressed. Moreover, a path from the placing table 16 to the bellows 13 and a path from the placing table 16 to the inner tube 12 are long, so that heat is less likely to be transmitted. Thus, the inner tube 12 and the bellows 13 are not heated to a high temperature, and even if they are exposed to the corrosive gas, the high temperature corrosion is suppressed. Accordingly, in the inner tube 12, the bellows 13, and the outer tube 14 which are metal members, the high temperature corrosion of these members is suppressed, so that the product lives of these members are extended, and also the metal contamination caused by these members is suppressed.

Moreover, in the structure described above, the bellows 13 is expanded when the substrate 17 is transported, and is contracted when the substrate 17 is subjected to plasma processing. Thus, products and by-products adhering to a surface of the bellows 13 are reduced. Particularly, in the plasma CVD apparatus, since the formation of a film on the surface of the bellows 13 is reduced, generation of particles which is caused by the peeling of the formed thin film is reduced.

Furthermore, in the structure described above, the back-surface side of the placing table 16 is at atmospheric pressure. In the plasma processing apparatus, the placing table 16 is provided with various parts such as: an electrostatic attraction electrode for electrostatically attracting the substrate 17; a bias electrode for applying a bias to the substrate 17; a heater for heating the substrate 17; a flow passage for a coolant to control the temperature of substrate 17; and a temperature sensor for detecting the temperatures of the substrate 17 and the placing table 16. By disposing connection portions of these parts at the atmospheric-pressure side, electric discharge can be prevented in portions to which a high voltage is applied such as the electrostatic attraction electrode, the bias electrode, and the heater. Moreover, in the connection portion to the flow passage, even if the coolant leaks, the leakage occurs in the atmosphere side. Thus, the inside of the vacuum chamber 11 is not contaminated.

Additionally, in the structure described above, the upper flange 13a of the bellows 13 divides the entirety into two sides: the placing table 16 side that is moved vertically; and the inner tube 12 side that is fixed. Thus, it is possible to reduce the volume and weight of driven portions inside the vacuum chamber 11, and thus to reduce a load on the drive mechanism 24. Moreover, a pressure by atmospheric pressure may possibly be applied to the back surface of the placing table 16 due to failure of the drive mechanism 24 or the like, in which case the bellows 13 moves in the direction to contract. This is safer than a case where the bellows 13 moves in the direction to expand, and prevents the bellows 13 from breaking.

### INDUSTRIAL APPLICABILITY

The present invention is preferably applied to a plasma processing apparatus such as a plasma CVD apparatus or a plasma etching apparatus used to manufacture a semiconductor device. However, the present invention is not limited to the apparatus manufacturing a semiconductor device, and can be applied to an apparatus manufacturing other products, as long as the apparatus is one in which a bellows is used in a drive portion in a vacuum chamber and a corrosive gas is used on the bellows in the vacuum chamber.

## Claims

1. A structure of a substrate supporting table which is used in a processing apparatus using a corrosive gas in a vacuum chamber, and which includes a drive mechanism to change a position of a substrate to be processed, the structure comprising:
a cylindrical inner tube which has one end portion thereof attached to a periphery of an opening in an inner wall of the vacuum chamber with a first sealing member in between;
a bellows which is disposed on an outer circumferential side of the inner tube, and which has one end portion thereof attached to another end portion of the inner tube with a second sealing member in between;
a cylindrical outer tube which is disposed on an outer circumferential side of the bellows, and which has one end portion thereof attached to another end portion of the bellows with a third sealing member in between;
a disc-shaped placing table which is attached to close an opening in another end portion of the outer tube with a fourth sealing member in between, and on which the substrate is placed;
a cover member which is provided in tight contact with the outer tube to cover an entire surface of the outer tube, and which is made of a corrosion resistant material; and
a drive member which is attached to a back surface of the placing table through the opening in the inner wall of the vacuum chamber and an inside of the inner tube, and which is driven by the drive mechanism.

2. A structure of a substrate supporting table which is used in a processing apparatus using a corrosive gas in a vacuum chamber, and which includes a drive mechanism to change a position of a substrate to be processed, the structure comprising:
a cylindrical inner tube which has a lower end portion thereof attached to a periphery of an opening in a bottom portion of the vacuum chamber with a first sealing member in between;
a bellows which is disposed on an outer circumferential side of the inner tube, and which has an upper end portion thereof attached to an upper end portion of the inner tube with a second sealing member in between;
a cylindrical outer tube which is disposed on an outer circumferential side of the bellows, and which has a lower end portion thereof attached to a lower end portion of the bellows with a third sealing member in between;
a disc-shaped placing table which is attached to close an opening in an upper end portion of the outer tube with a fourth sealing member in between, and on which the substrate is placed;
a cylindrical cover member which is provided in tight contact with the outer tube to cover an entire surface of the outer tube, and which is made of a corrosion resistant material; and
a drive member which is attached to a back surface of the placing table through the opening in the inner wall of the vacuum chamber and an inside of the inner tube, and which is driven by the drive mechanism.

3. The structure of the substrate supporting table according to claim 1 or 2, wherein at least one of bonding of the inner tube and the bellows, which is performed instead of using the second sealing member, and bonding of the bellows and the outer tube, which is performed instead of using the third sealing member, is performed.

4. The structure of the substrate supporting table according to any one of claims 1 to 3, wherein a cylindrical exterior member made of a corrosion resistant material is further provided on an outer circumferential side of the cover member to cover an entire surface of the cover member.

5. The structure of the substrate supporting table according to any one of claims 1 to 4, wherein the processing apparatus is a plasma processing apparatus.

6. A plasma processing device comprising the structure of the substrate supporting table according to any one of claims 1 to 4.
